# EUROPÄISCHE PATENTSCHRIFT

(11) **EP 3 139 714 B1**
(45) Veröffentlichungstag und Bekanntmachung des Hinweises auf die Patenterteilung: **27.02.2019**
(21) Anmeldenummer: 16187150.4
(22) Anmeldetag: 02.09.2016
(51) Int. Cl.: H05K 5/02

(54) **GEHÄUSE FÜR EINE ELEKTRONISCHE BAUGRUPPE**
HOUSING FOR AN ELECTRONIC COMPONENT
BOITIER DE COMPOSANT ELECTRONIQUE

(30) Priorität: 04.09.2015 CH 12742015
(43) Veröffentlichungstag der Anmeldung: 08.03.2017
(73) Patentinhaber: Griesser Holding AG, 8355 Aadorf (CH)
(72) Erfinder: Ravelli, Gian M., 8408 Winterthur (CH)
(74) Vertreter: Gachnang, Hans Rudolf

(56) Entgegenhaltungen:
- DE-A1-102013 016 760
- DE-U1-202007 007 411
- US-A1- 2008 171 464
- US-B2- 6 540 547

## Beschreibung

Gegenstand der Erfindung ist ein Gehäuse für eine elektronische Baugruppe, ein System zum Befestigen eines Kabels sowie ein Verfahren zum Befestigen eines Kabels an einem Gehäuse gemäss dem Oberbegriff der Patentansprüche 1, 9 und 10.

Elektronische Baugruppen bzw. Steuerungen sind üblicherweise in Gehäusen angeordnet. Solche Gehäuse sind vorzugsweise aus elektrisch isolierendem Kunststoff gefertigt und umfassen in der Regel ein oder mehrere in Spritzgiesstechnik gefertigte Gehäuseteile sowie Schnittstellen für die Speisung und/oder für die Kommunikation. Leitungsgebundene Schnittstellen umfassen elektrische Kontaktelemente wie z.B. Lötösen, Anschlussklemmen oder Steckkontakte zum Anschliessen von elektrischen Leitern der Anschlusskabel. Um zu verhindern, dass sich solche Verbindungen lösen, wenn auf die Anschlusskabel Zugkräfte wirken, ist es bekannt, Zugentlastungen vorzusehen. Dabei wird in der Regel ein Abschnitt des Anschlusskabels mittels einer Klemmvorrichtung am Gehäuse befestigt. Auf das Anschlusskabel einwirkende Kräfte wirken demnach über die Klemmvorrichtung auf das Gehäuse. Die Kontaktstellen, an denen Leiter des Anschlusskabels mit Kontaktelementen der elektronischen Baugruppe verbunden sind, werden hingegen durch solche auf das Kabel wirkende Kräfte nicht belastet.

Aus der EP1445844 ist es bekannt, bei einem Gehäuse einen länglichen, sprungbrettartigen Schenkel auszubilden, dessen eines Ende an einem Gehäuseteil verankert ist, und dessen anderes Ende frei an diesem Gehäuseteil hervorragt. Im Bereich des Schenkels umfasst dieser Gehäuseteil eine Ausnehmung. Zum Befestigen eines Kabels am Gehäuse, wird dieses Kabel in Längsrichtung an den Schenkel angelegt und daran mittels eines Kabelbinders kraftschlüssig befestigt. Kabelbinder sind Bänder, die mindestens an einer der Bandseiten eine Zahnung und am Bandende eine Öse mit einem elastisch federnden Rückhalteelement bzw. einer Zunge umfassen. Wird das Bandende in die Öse eingeschlauft und angezogen, verrastet die Zunge mit der Zahnung und verhindert, dass sich die Schlaufe wieder lösen kann.

Die Befestigung eines Kabels mit einem Kabelbinder an einem Schenkel des Gehäuses ist nur dann einfach zu bewerkstelligen, wenn der Schenkel gut zugänglich ist und der zu einer Schlaufe gebogene Kabelbinder vom freien Ende her über den Schenkel geschoben werden kann. Häufig ist diese gute Zugänglichkeit jedoch nicht gegeben, beispielsweise wenn Leiter des Kabels bereits an Kontaktelemente der elektronischen Baugruppe angeschlossen sind und/oder wenn weitere Kabel mit der Baugruppe verbunden sind und/oder wenn das Gehäuse mit der elektronischen Baugruppe an einem schlecht zugänglichen Installationsort angeordnet ist.

Ist ein Kabel an einem solchen hebelartigen Schenkel befestigt, können vom Kabel auf diesen Schenkel wirkende Kräfte bzw. Drehmomente dazu führen, dass der Schenkel bricht oder umgebogen wird. Eine ausreichende Entlastung der Kontaktstellen von auf das Kabel wirkenden Kräften ist dann nicht mehr sichergestellt.

Aus der DE102013016760A1 ist ein Elektronikgehäuse bekannt, an dessen Aussenwand eine Führungs- und Haltevorrichtung mit mindestens einer Auflagefläche für ein Kabel ausgebildet ist. Unterhalb der Auflagefläche ist ein bogenförmig gekrümmter Führungskanal zur Führung und Aufnahme eines Abschnitts eines Kabelbinders angeordnet. Der Führungskanal ist aussen von einer Stirnwand begrenzt, die eine Ausnehmung zur einfachen Kontrolle der Lage des Kabelbinders aufweist. Die Führungsvorrichtung ist ein integraler Bestandteil des Elektronikgehäuses.

Eine Aufgabe der vorliegenden Erfindung ist es deshalb, ein Gehäuse für eine elektronische Baugruppe und ein System sowie ein Verfahren zum einfachen Befestigen eines Kabels an diesem Gehäuse zu schaffen.

Diese Aufgabe wird gelöst durch ein Gehäuse gemäss den Merkmalen des Patentanspruchs 1, durch ein System sowie durch ein Verfahren zum Befestigen eines Kabels an diesem Gehäuse gemäss den Merkmalen der Patentansprüche 9 und 10.

Das Gehäuse ist vorzugsweise aus Kunststoff gefertigt und umfasst eine Haltevorrichtung mit mindestens einem Haltesteg, an dem ein Kabel mittels eines Kabelbinders oder eines anderen flexiblen länglichen Befestigungsorgans befestigt werden kann. In einem Befestigungsabschnitt ist der Haltesteg freiliegend ausgebildet, sodass er einschliesslich des am Haltesteg anliegenden Kabelabschnitts von einem Kabelbinder umschlungen werden kann. Durch Festziehen bzw. Verbinden der beiden Trume bzw. Enden des flexiblen Befestigungsorgans kann so der im Befestigungsabschnitt angeordnete Kabelabschnitt kraftschlüssig mit dem Haltesteg verbunden werden.

Das Gehäuse umfasst eine Führungsvorrichtung, die zum Umlenken des vorderen Endes eines länglichen Befestigungsorgans um den Haltesteg herum ausgebildet ist, wenn dieses Befestigungsorgan von einer Bedienseite her seitlich am Haltesteg vorbei vorgestossen wird. Die Führungsvorrichtung ist als Umlenkvorrichtung ausgebildet, derart, dass das vordere Ende des Befestigungsorgans beim Einstossen mühelos um das Halteelement herumgeführt wird und auf der gegenüberliegenden Seite des Halteelements von der Bedienseite her wieder ergriffen und mit dem anderen Ende des Befestigungsorgans verbunden werden kann. Beim Festziehen bzw. Verbinden der beiden Trume werden der Befestigungsabschnitt des Halteelements sowie der an diesem Befestigungsabschnitt anliegende Abschnitt des Anschlusskabels gemeinsam vom Befestigungsorgan umschlungen und durch dessen Krafteinwirkung kraftschlüssig miteinander verbunden.

Der Haltesteg kann eine Ausrichthilfe umfassen, die es erleichtert, das Kabel in der vom Haltesteg vorgegebenen Anlegerichtung auszurichten. Insbesondere kann diese Ausrichthilfe beispielsweise eine Kerbe oder Rinne sein, in die der zu befestigende Kabelabschnitt achsparallel eingelegt werden kann.

Die Führungsfläche der Führungsvorrichtung ist vorzugsweise glatt, sodass der Reibwiderstand beim Führen und Umlenken des Befestigungsorgans möglichst gering ist.

Die Führungsfläche ist vorzugsweise zumindest bereichsweise quer zur Anlegerichtung konkav gewölbt bzw. gekrümmt. Die konkav gekrümmte Führungsfläche kann einen oder mehrere Abschnitte umfassen. Die Krümmung kann in jedem dieser Abschnitte kontinuierlich oder durch zwei oder mehrere ebene Teilabschnitte diskontinuierlich ausgebildet sein. Insbesondere schliessen die Ausdrücke "Krümmung" bzw. "gekrümmt" im Zusammenhang mit der vorliegenden Erfindung auch V-förmig zusammengefügte ebene Flächenbereiche ein. Als Teilabschnitte werden Teile von Abschnitten bezeichnet, die sich durch eine gemeinsame Eigenschaft wie z.B. eine Ausrichtung oder Form der Führungsfläche von anderen Bereichen der jeweiligen Abschnitte unterscheiden.

Aneinander angrenzende bzw. benachbarte Abschnitte oder Teilabschnitte dieser Führungsfläche schliessen einen stumpfen Winkel ein. Dadurch wird sichergestellt, dass das vordere Ende des Befestigungsorgans leicht um den Haltesteg herum umgelenkt werden kann und nicht an der Führungsvorrichtung ansteht.

Die Führungsvorrichtung ist so beabstandet zum Befestigungsbereich des Halteelements angeordnet, dass zwischen der Führungsfläche und dem Haltesteg ein ausreichend grosser Freiraum zum Durchschlaufen des Befestigungsorgans verbleibt.

Vorzugsweise ist der Anlegebereich des Haltestegs, an den das Kabel angelegt wird, an der von der Führungsfläche abgewandten Seite des Haltestegs angeordnet. Der Abstand zwischen dem Haltesteg und der Führungsfläche kann bei solchen Ausführungsformen der Haltevorrichtung vergleichsweise klein gehalten werden und ist unabhängig vom Durchmesser des zu befestigen den Kabels.

Bei Alternativen Ausführungsformen der Haltevorrichtung mit einem grösseren Zwischenraum zwischen dem Haltesteg und der Führungsvorrichtung könnte der Anlegebereich für das Kabel auch an jener Seite des Haltestegs ausgebildet sein, die der Führungsfläche zugewandt ist.

Die Breite des Haltestegs im Befestigungsabschnitt liegt vorzugsweise etwa zwischen der Hälfte und dem Doppelten des Durchmessers der zu befestigende Kabel. Sie wird so gewählt, dass der Haltesteg ausreichend stabil ist, aber nicht übermässig viel Platz beansprucht.

Vorzugsweise ist die Breite der Führungsvorrichtung etwas grösser als die Breite des Haltestegs im Befestigungsabschnitt. Dies erleichtert das Einführen des Befestigungsorgans von der Bedienseite her in den Zwischenraum zwischen dem Haltesteg und der Führungsfläche.

Der Haltesteg ist vorzugsweise an mehreren Stellen, beispielsweise an den sich gegenüberliegenden Stirnseiten, am Gehäuse verankert. Dadurch erhöht sich die Stabilität der Haltevorrichtung. Besonders vorteilhaft ist es, Haltestege einstückig an einem z.B. in Spritzgiesstechnik gefertigten primären Gehäuseteil auszubilden, insbesondere wenn dieser primäre Gehäuseteil auch Mittel zum Befestigen einer Platine der elektronischen Baugruppe umfasst, an der Kontaktelemente der Schnittstelle angeordnet sind. Falls Anschlusskabel an den Haltestegen befestigt sind, wirkt die Zugentlastung dieser Kabel auch dann, wenn dieser primäre Gehäuseteil zusammen mit der elektronischen Baugruppe bewegt wird. So kann der primäre Gehäuseteil beispielsweise problemlos von einem sekundären Gehäuseteil getrennt werden, der an einem Installationsort befestigt ist. Ein solcher sekundärer Gehäuseteil kann insbesondere als Montageboden ausgebildet sein, der beispielsweise eine Klemmvorrichtung zum Befestigen an einer Hutschiene und/oder Ausnehmungen zum Festschrauben an einem Träger umfasst.

Die Umlenkvorrichtung kann vollständig oder teilweise am primären Gehäuseteil angeordnet sein. Bei einer besonders vorteilhaften Ausgestaltung des Gehäuses ist ein mittlerer Abschnitt der Umlenkvorrichtung an einem sekundären Gehäuseteil angeordnet. Beidseitig quer zur Anlegerichtung daran angrenzende äussere Abschnitte der Führungsvorrichtung sind jedoch am primären Gehäuseteil ausgebildet. In Aufsicht bzw. von der Bedienseite her gesehen überlappen sich der Anlege- bzw. Haltesteg und die äusseren Abschnitte der Führungsvorrichtung nicht. Der primäre und der sekundäre Gehäuseteil können demnach im Bereich der Haltevorrichtung ohne Hinterschneidungen ausgebildet sein. Solche Spritzgiessteile können effizient und kostengünstig mit vergleichsweise einfachen Werkzeugen hergestellt werden, die keine aufwändigen Schieber zum Entformen der Teile aufweisen.

Der primäre und der sekundäre Gehäuseteil können in einer definierten Weise zusammengefügt und miteinander verbunden werden. So zusammengesetzt ergänzen sich die Abschnitte der Führungsvorrichtung so, dass die zusammengesetzte Führungsfläche keine störenden Absätze aufweist. Falls ein Befestigungsorgan nur in einer der beiden möglichen Richtungen von der Führungsfläche umgelenkt werden soll, wären Absätze zwischen den Abschnitten der Führungsvorrichtung tolerierbar, falls sie in der jeweiligen Umlenkrichtung kein Hindernis für das Befestigungsorgan darstellen.

Anhand einiger Figuren wird die Erfindung näher beschrieben. Dabei zeigen
- Figur 1: ein perspektivisch dargestelltes Gehäuse mit einem primären und einem sekundären Gehäuseteil,
- Figur 2: ein schematisch dargestellter Querschnitt eines Gehäuses im Bereich der Haltevorrichtung,
- Figur 3: eine perspektivische Darstellung des im Bereich der Haltevorrichtung quer zur Längsrichtung aufgeschnittenen primären Gehäuseteils aus Figur 1,
- Figur 4: eine perspektivische Darstellung des in gleicher Weise aufgeschnittenen sekundären Gehäuseteils aus Figur 1,
- Figur 5: eine perspektivische Darstellung des aufgeschnittenen Gehäuses aus Figur 1 mit zusammengesetztem primärem und sekundärem Gehäuseteil,
- Figur 6: eine Teilansicht des im Bereich der Haltevorrichtung in Längsrichtung aufgeschnittenen Gehäuses aus Figur 1,
- Figur 7: einen Querschnitt der Haltevorrichtung im Bereich eines Haltestegs.

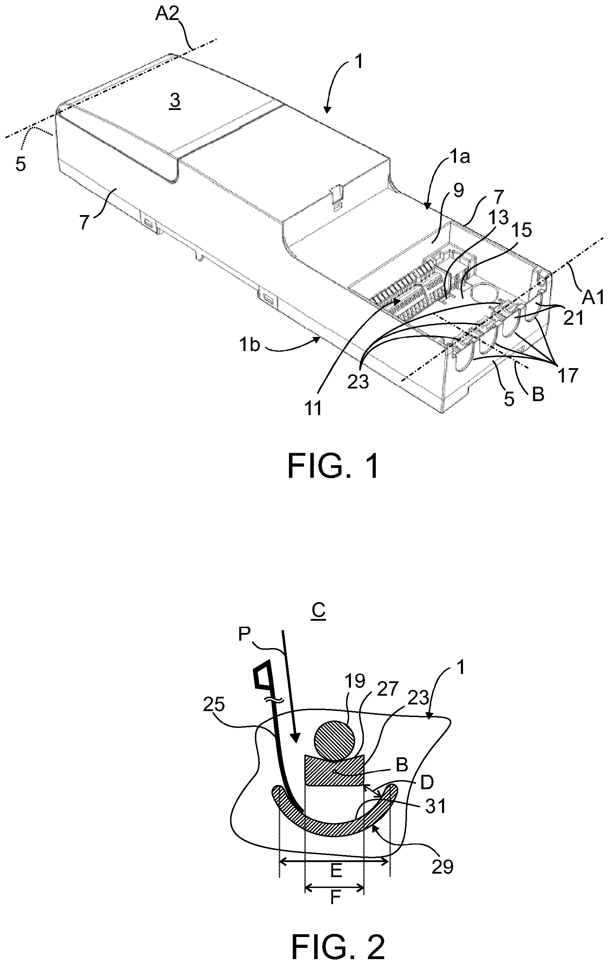

Figur 1 zeigt in perspektivischer Darstellung eine bevorzugte Ausführungsform der Erfindung mit einem länglichen Gehäuse 1. Das Gehäuse 1 umfasst einen haubenartig ausgebildeten primären Gehäuseteil 1a mit einem näherungsweise rechteckigen Grundriss. Der unten offene primäre Gehäuseteil 1a ist beispielsweise mittels einrastender Schnappelemente wieder lösbar mit einem korrespondierenden, plattenartig ausgebildeten sekundären Gehäuseteil 1b verbunden, wobei der sekundäre Gehäuseteil 1b die untenliegende Öffnung des primären Gehäuseteils 1a schliesst bzw. mindestens teilweise überdeckt. Zwei Deckel 3 sind zum Abdecken von Anschlussräumen des Gehäuses 1 vorzugsweise im Bereich der jeweiligen kurzen Seitenwände 5 des primären Gehäuseteils 1a wieder lösbar und um Schwenkachsen A1, A2 schwenkbar oben an den langen Seitenwänden 7 des primären Gehäuseteils 1a angelenkt. Der vordere Deckel 3 ist nicht dargestellt, sodass der darunter angeordnete Anschlussraum sichtbar ist. Dieser Anschlussraum ist durch Endabschnitte der beiden langen Seitenwände 7, durch die vordere kurze Seitenwand 5, durch eine beabstandet dazu angeordnete Innenwand 9 sowie durch einen Zwischenboden 15, der an die kurze Seitenwand 5 angrenzt, begrenzt.

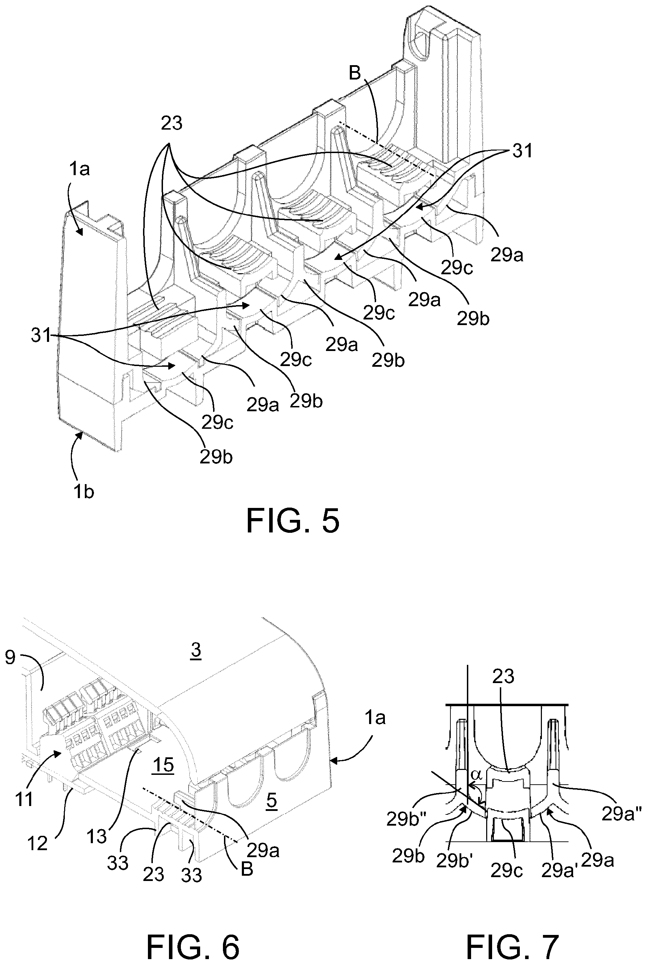

Im Inneren des Gehäuses 1 ist eine elektronische Baugruppe angeordnet, von der nur die Anschlussklemmen 11 zum Anschliessen von Leitern der Anschlusskabel im Anschlussraum sichtbar sind. Die Anschlussklemmen 11 und weitere Elemente der elektronischen Baugruppe (nicht sichtbar) sind auf einer rechteckigen Leiterplatte 12 angeordnet (Figur 6), die am primären Gehäuseteil 1a befestigt ist. Für diesen Zweck kann der primäre Gehäuseteil 1a z.B. federnde Rastelemente 13 umfassen. Insbesondere können solche Rastelemente 13 an den beiden Zwischenböden 15 nach unten ragen.

Die kurzen Seitenwände 5 sind als Anschlusswände mit mehreren Ausnehmungen 17 zum Durchführen von Verbindungskabeln 19 (Figur 2) von aussen in den Anschlussraum des Gehäuses 1 ausgebildet. Vorzugsweise sind die Ausnehmungen 17 U-förmig ausgebildet und zur Oberkante der jeweiligen Seitenwand 5 hin offen. Zum Anschliessen von Verbindungsleitungen kann das zugehörige Kabel 19 einfach in die Ausnehmung 17 eingelegt werden, wenn der zugehörige Deckel 3 vorgängig vom primären Gehäuseteil 1a getrennt worden ist. Ein Einschlaufen von Kabeln 19 ist somit nicht erforderlich. Vorzugsweise ist zumindest ein Teil der Ausnehmungen 17 bei noch unbenutzten neuen Gehäusen 1 durch leicht ausbrechbare dünne Schliessplatten 21 verdeckt. Bei Ausnehmungen 17, die nicht als Kabeldurchführung genutzt werden, können die Schliessplatten 21 als Schutz am Gehäuse 1 belassen werden. Eine der Ausnehmungen 17, die bei jeder elektronischen Baugruppe für die Durchführung eines Speisekabels erforderlich ist, ist vorzugsweise etwas grösser als die anderen Ausnehmungen 17 und ohne Schliessplatte 21 ausgebildet. Bei jedem der Anschlussräume umfasst das Gehäuse 1 eine Haltevorrichtung mit mindestens einem Haltesteg 23, der an der jeweiligen Seitenwand 5 in einer Anlegerichtung B nach innen hervorragt und zum Anlegen eines Kabels 19 in in dieser Anlegerichtung B ausgebildet ist. Jeder Haltesteg 23 umfasst einen freiliegenden Befestigungsabschnitt zum Befestigen dieses Kabels 19 mittels eines Kabelbinders bzw. allgemein mittels eines länglichen flexiblen Befestigungsorgans 25. Die Höhenlage der Haltestege 23 am Gehäuse 1 insbesondere relativ zur Oberkante der jeweiligen Seitenwand 5 kann unterschiedlich sein, da beispielsweise zu erwarten ist, dass ein anzuschliessendes Speisekabel einen grösseren Durchmesser aufweist als Kabel 19 mit Steuerleitungen.

Figur 2 zeigt schematisch einen Querschnitt eines Gehäuses 1 quer zur Anlegerichtung B im Bereich eines Befestigungsabschnitts, wobei ein Kabel 19 achsparallel zur Anlegerichtung B an einem im Querschnitt V-förmigen Anlegebereich 27 des Haltestegs 23 anliegt. Die Anlegerichtung B, in der ein Kabel 19 zum Befestigen an den Haltesteg 23 angelegt wird, ist durch die Gestalt und Ausrichtung des Haltestegs 23 vorgegeben. Ein länglicher, rinnenförmiger Anlegebereich 27 erleichtert die Ausrichtung des zu befestigenden Kabelabschnitts 19 am Haltesteg 23. Mindestens in einem Befestigungsabschnitt hat der Haltesteg 23 einen freiliegenden Querschnitt. Der Haltesteg 23 kann somit im Befestigungsabschnitt vom länglichen flexiblen Befestigungsorgan 25, beispielsweise von einem Kabelbinder, vollständig umschlungen werden.

Wenn der Haltesteg 23 und der daran anliegende Kabelabschnitt 19 in dieser Weise umschlungen und die Enden des Befestigungsorgans 25 festgezogen und miteinander verbunden werden, ist der Kabelabschnitt 19 kraftschlüssig am Haltesteg 23 befestigt. Der Haltesteg 23 selbst ist bei einer bevorzugten Ausführungsform brückenartig ausgebildet und in Anlegerichtung B gesehen auf beiden Seiten des Befestigungsabschnitts mit dem Gehäuse 1 verbunden bzw. am primären Gehäuseteil 1a angeformt. Alternativ könnte der Haltesteg 23 auch nur einseitig des Befestigungsabschnitts oder in anderer Weise mit dem Gehäuse 1 verbunden sein.

Bezüglich der Anlegerichtung B radial beanstandet zum Haltesteg 23 ist eine Führungsvorrichtung 29 mit einer quer zur Anlegerichtung B konkav gewölbten Führungsfläche 31 mit dem Gehäuse 1 verbunden bzw. am Gehäuse 1 verankert. Sie ist so ausgebildet, dass sie das vordere Trum bzw. Ende des Befestigungsorgans 25 umlenkt und um den Haltesteg 23 herumführt, wenn es von einer Bedienseite C oberhalb des Haltestegs 23 her auf der einen Seite des Haltestegs 23 in Richtung des Pfeils P hinunter gestossen wird. Die Bedienseite C ist durch den Anlegebereich des Haltestegs 23 zum Anlegen eines Kabels definiert.

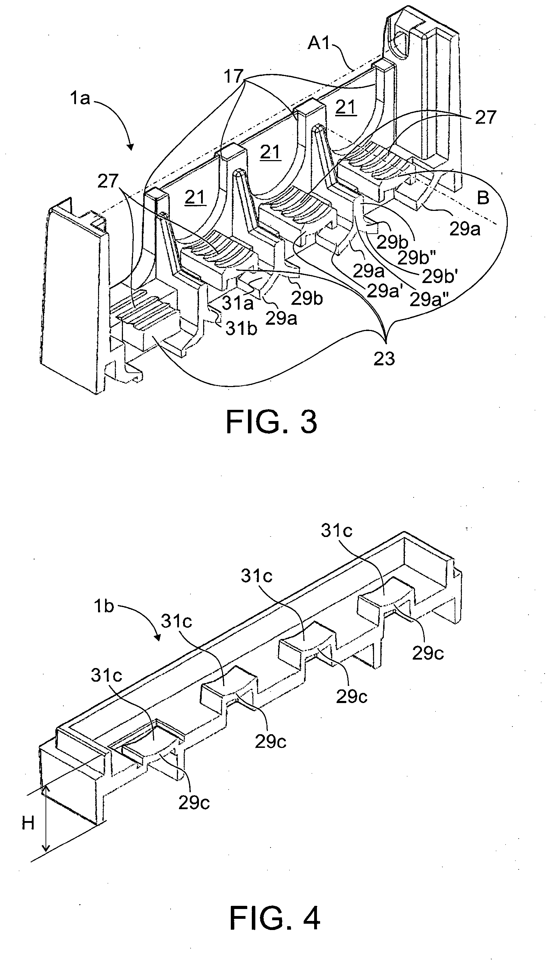

Anstelle einer kontinuierlichen Krümmung kann die Führungsfläche 31 auch diskontinuierlich gekrümmt sein, wobei aneinander angrenzende Abschnitte oder Teilabschnitte der Führungsfläche 31 je einen stumpfen Winkel α (Figur 7) einschliessen, der grösser als 90° und kleiner oder gleich 180° ist und vorzugsweise zwischen 135° und 180° liegt. Dadurch wird sichergestellt, dass das führende Ende des Befestigungsorgans 25 beim Einstossen nur mit geringem Widerstand von der Führungsfläche 31 der Führungsvorrichtung 29 umgelenkt wird und nicht an dieser ansteht. Die Führungsfläche 31 kann insbesondere einen U-förmigen Querschnitt aufweisen und zwei Schenkel umfassen, die sich nach oben erstrecken, vorzugsweise bis auf das Niveau des Anlegebereichs 27 des Haltestegs 27 oder darüber hinaus (Figur 3). Die Krümmungsradien in verschiedenen Abschnitten oder Teilabschnitten können gleich oder unterschiedlich sein.

Der minimale Abstand D zwischen dem Befestigungsabschnitt des Haltestegs 23 und der Führungsfläche 31 ist so bemessen, dass das Befestigungsorgan 25 problemlos hindurchgeführt werden kann. Dieser minimale Abstand D kann beispielsweise zwischen 2 mm und 10 mm betragen.

Vorzugsweise ist die Breite E der Führungsfläche 31 grösser als die Breite F des Haltestegs 23 im Befestigungsabschnitt. Von der Bedienseite C her gesehen überragt demnach die Führungsfläche 31 den Haltesteg 23 beidseitig. Dies erleichtert das Einführen eines Befestigungsorgans 25 in den Zwischenraum zwischen dem Haltesteg 23 und der Führungsfläche 31.

Der Haltesteg 23 und die Umlenkvorrichtung 29 können an einem gemeinsamen Teil des Gehäuses 1 angeordnet sein, beispielsweise in Gestalt von Profilen, die an einer Gehäusewand hervorragen, wie dies in Figur 2 schematisch dargestellt ist. An den stirnseitigen Enden des Haltestegs 23 und der Umlenkvorrichtung 29 können optional Befestigungselemente wie z.B. vorstehende Bolzen und/oder Vertiefungen bzw. Bolzenaufnahmen ausgebildet sein, die eine Verankerung an korrespondierenden Befestigungselementen eines angrenzenden Gehäuseteils ermöglichen (nicht dargestellt).

Figur 3 zeigt einen Querschnitt des primären Gehäuseteils 1a aus Figur 1 im Bereich von vier Haltestegen 23, die nebeneinander an der kurzen Seitenwand 5 hervorragen, in perspektivischer Darstellung vom Gehäuseinneren her gesehen. Die Anlegebereiche 27 weisen eine sägezahnartige Riffelung auf, die sich beim Anpressen eines Kabels 19 in dessen äusseren Isolationsmantel eingräbt. Durch diese Verzahnung ist das Kabel 19 nicht nur kraftschlüssig, sondern auch formschlüssig am Haltesteg 23 befestigt und ist so insbesondere gegen Zugkräfte am Kabel in Anlegerichtung B besser gesichert. Auf beiden Seiten jedes Haltesteges 23 sind seitliche Abschnitte 29a, 29b der Führungsvorrichtung 29 angeordnet, die keine Hinterschneidungen mit den jeweiligen Haltestegen 23 aufweisen. Zwischen diesen seitlichen Abschnitten 29a, 29b der Führungsvorrichtung 29 ist unterhalb jedes Haltestegs 23 eine Ausnehmung ausgebildet.

Figur 4 zeigt analog zu Figur 3 einen Querschnitt des sekundären Gehäuseteils 1b aus Figur 1 und Figur 5 in gleicher Weise die Anordnung der zusammengesetzten Gehäuseteile 1a und 1b bei einem Gehäuse 1. Die mittleren Abschnitte 29c sind am plattenartigen sekundären Gehäuseteil 1b der Führungsvorrichtung 29 so angeordnet und ausgebildet, dass sie genau in die Ausnehmungen zwischen den zugehörigen Abschnitten 29a und 29b der Führungsvorrichtung 29 am primären Gehäuseteil 1a passen und bei zusammengesetztem Gehäuse 1 die Führungsflächen 31 vervollständigen. Die hochragenden Schenkel 29a",29b" von je zwei aneinander angrenzenden seitlichen Abschnitten 29a, 29b der Führungsvorrichtung 29 sind zusammengefasst zu einem einzigen gemeinsamen Schenkel ausgebildet.

Figur 6 zeigt einen in Längsrichtung aufgeschnittenen Abschnitt des primären Gehäuseteils 1a und des Deckels 3 im Bereich der kurzen Seitenwand 5. Die Haltestege 23 und der Zwischenboden 15 sowie die Seitenwände 3 und 7 sind vorzugsweise als einstückiges Spritzgiessteil hergestellt. Da sich die seitlichen Abschnitte 29a, 29b der Führungsvorrichtung 29 und die Haltestege 23 nicht hinterschneiden, lässt sich diese mit einer zweiteiligen Form ohne zusätzliche Schieber einfach herstellen. Sowohl die Haltestege 23 als auch die Abschnitte 29a, 29b sind in der Anlegerichtung B auf beiden Seiten des Befestigungsabschnitts am primären Gehäuseteil 1a verankert, nämlich an der kurzen Seitenwand 5 und am Zwischenboden 15. Der Befestigungsabschnitt ist in der Anlegerichtung B begrenzt durch zwei am Haltesteg 23 nach unten ragende Lamellen 33. Diese begrenzen zusammen mit den unteren Stirnflächen der Abschnitte 29a, 29b einen Aufnahmeraum zum Aufnehmen des jeweiligen mittleren Abschnittes 29c der der Führungsvorrichtung 29 am sekundären Gehäuseteil 1b.

Der sekundäre Gehäuseteil 1b ist vorzugsweise als einstückiges Spritzgiessteil gefertigt, das ebenso wie der primäre Gehäuseteil 1a vorzugsweise keine Hinterschneidungen aufweist und mit einem zweiteiligen Werkzeug einfach gefertigt werden kann. Die Bauhöhe H des sekundären Gehäuseteils 1b kann vergleichsweise klein sein, wenn nicht die ganze Führungseinrichtung 29, sondern nur der tiefstliegende mittlere Abschnitt 29c am sekundären Gehäuseteil 1b angeordnet ist. Entsprechend der Höhenlage der Haltestege 23 und der Abschnitte 31a, 31b der Führungsflächen 31 am primären Gehäuseteil 1a kann auch die Höhenlage des mittleren Abschnitts 31c der Führungsfläche 31 am sekundären Gehäuseteil 1b unterschiedlich sein.

Figur 7 zeigt ein Detail eines Gehäusequerschnitts im Bereich der Haltevorrichtung. Jeder der Abschnitte 29a, 29b der Führungsvorrichtung 29 umfasst wiederum zwei Schenkel bzw. Teilabschnitte 29a', 29a" und 29b', 29b", die je einen stumpfen Winkel α einschliessen, wobei dieser Winkel α vorzugsweise nicht kleiner als 135° ist.

## Patentansprüche

1. Gehäuse (1) für eine elektronische Baugruppe, umfassend eine Haltevorrichtung mit mindestens einem Haltesteg (23), der einen Anlegebereich zum Anlegen eines Kabels (19) in einer Anlegerichtung (B) und einen freiliegenden Befestigungsabschnitt zum Befestigen dieses Kabels am Haltesteg (23) mittels eines länglichen flexiblen Befestigungsorgans (25) aufweist, wobei eine Führungsvorrichtung (29) mit einer Führungsfläche (31) dazu ausgebildet ist, ein vorderes Ende des Befestigungsorgans (25) auf der vom Anlegebereich des Haltestegs (23) abgewandten Seite um den Haltesteg (23) herum umzulenken, wenn dieses von einer Bedienseite (C) her zugeführt wird, sodass es auf der Bedienseite (C) wieder ergriffen werden kann, **dadurch gekennzeichnet, dass** der Haltesteg (23) an einem primären Gehäuseteil (1a) angeordnet ist, der wieder lösbar mit einem sekundären Gehäuseteil (1b) verbindbar ist, und dass mindestens ein Abschnitt (29a, 29b) der Führungsvorrichtung (29) mit einem zugehörigen Abschnitt (31a, 31b) der Führungsfläche (31) am primären Gehäuseteil (1a) angeordnet ist und ein Abschnitt (29c) der Führungsvorrichtung (29) mit einem zugehörigen Abschnitt (31c) am sekundären Gehäuseteil (1b).

2. Gehäuse (1) nach Anspruch 1, **dadurch gekennzeichnet, dass** die Breite (E) der Führungsfläche (31) grösser ist als die Breite (F) des Haltestegs (23), sodass die Führungsfläche (31) den Haltesteg (23) quer zur Anlegerichtung (B) überragt.

3. Gehäuse (1) nach einem der Ansprüche 1 oder 2, **dadurch gekennzeichnet, dass** der Haltesteg (23) und/oder der mindestens eine Abschnitt (29a, 29b) der Führungsvorrichtung (29) in Anlegerichtung (B) auf beiden Seiten des Befestigungsabschnitts am primären Gehäuseteil (1a) verankert sind.

4. Gehäuse (1) nach einem der Ansprüche 1 bis 3, **dadurch gekennzeichnet, dass** der Haltesteg (23) und der mindestens eine Abschnitt (29a, 29b) der Führungsvorrichtung (29) in Anlegerichtung (B) gesehen keine Hinterschneidung aufweisen.

5. Gehäuse (1) nach Anspruch 4, **dadurch gekennzeichnet, dass** der primäre Gehäuseteil (1a) zwei Abschnitte (31a, 31b) der Führungsfläche (31) umfasst, die bei zusammengesetztem Gehäuse (1) in Anlegerichtung (B) gesehen beidseitig an den Abschnitt (31c) der Führungsfläche (31) am sekundären Gehäuseteil (1b) angrenzen.

6. Gehäuse (1) nach einem der Ansprüche 1 bis 5, **dadurch gekennzeichnet, dass** die Abschnitte (31a, 31b, 31c) der Führungsfläche (31) in Bezug auf den Haltesteg (23) eine konkave Krümmung aufweisen.

7. Gehäuse (1) nach einem der Ansprüche 1 bis 6, **dadurch gekennzeichnet, dass** die Haltevorrichtung angrenzend an eine Ausnehmung (17) in der Seitenwand (5) des Gehäuses (1) angeordnet ist.

8. Gehäuse (1) nach einem der Ansprüche 1 bis 7, **dadurch gekennzeichnet, dass** mehrere Haltevorrichtungen mit je einem Haltesteg (23) und einer Führungsvorrichtung (29) bezüglich der Anlegerichtung (B) nebeneinander angeordnet sind.

9. System zum Befestigen eines Kabels (19) umfassend ein Gehäuse (1) nach einem der Ansprüche 1 bis 8 und ein längliches flexibles Befestigungsorgan (25) in Gestalt eines Kabelbinders.

10. Verfahren zum Befestigen eines Kabels (19) an einem Gehäuse (1) nach einem der Ansprüche 1 bis 8, **dadurch gekennzeichnet, dass** ein Abschnitt des Kabels (19) an einen Anlegebereich (27) des Haltestegs (23) angelegt wird, dass ein flexibles längliches Befestigungsorgan (25) von der Bedienseite (C) her seitlich am Kabel (19) und am Haltesteg (23) vorbei nach unten gestossen wird, dass das vordere Ende des Befestigungsorgans (25) durch die Führungsfläche (31) der Umlenkvorrichtung (29) umgelenkt und auf der anderen Seite des Haltestegs (23) wieder nach oben geführt wird, und dass die beiden Enden des Befestigungsorgans (25) festgezogen und miteinander verbunden werden.

## Claims

1. A housing (1) for an electronic component, comprising a retaining device having at least one retaining web (23) which has an installation area for laying a cable (19) in an installation direction (B) and an exposed fastening portion for fastening said cable to the retaining web (23) by means of an elongated flexible fastening member (25), wherein a guiding device (29) having a guide surface (31) is configured to deflect a front end of the fastening member (25) on the side facing away from the installation area of the retaining web (23) around the retaining web (23) if said fastening member is fed from an operating side (C), so that it can be grasped again on the operating side (C), **characterized in that** the retaining web (23) is arranged on a primary housing part (1a) which is connectable in a re-detachable way to a secondary housing part (1b), and at least one portion (29a, 29b) of the guiding device (29) having an associated portion (31a, 31b) of the guide surface (31) is arranged on the primary housing part (1a) and a portion (29c) of the guiding device (29) having an associated portion (31c) is arranged on the secondary housing part (1b).

2. The housing (1) according to Claim 1, **characterized in that** the width (E) of the guide surface (31) is greater than the width (F) of the retaining web (23), so that the guide surface (31) projects beyond the retaining web (23) transversely to the installation direction (B).

3. The housing (1) according to any one of Claims 1 or 2, **characterized in that** the retaining web (23) and/or the at least one portion (29a, 29b) of the guiding device (29) is/are anchored in the installation direction (B) on both sides of the fastening portion on the primary housing part (1a).

4. The housing (1) according to any one of Claims 1 to 3, **characterized in that** the retaining web (23) and the at least one portion (29a, 29b) of the guiding device (29), viewed in the installation direction (B), do not have an undercut.

5. The housing (1) according to Claim 4, **characterized in that** the primary housing part (1a) comprises two portions (31a, 31b) of the guide surface (31), which, when the housing (1) is assembled and viewed in the installation direction (B), adjoin the portion (31c) of the guide surface (31) on the secondary housing part (1b) on both sides.

6. The housing (1) according to any one of Claims 1 to 5, **characterized in that** the portions (31a, 31b, 31c) of the guide surface (31) have a concave curvature with respect to the retaining web (23).

7. The housing (1) according to any one of Claims 1 to 6, **characterized in that** the retaining device is arranged adjoining a recess (17) in the side wall (5) of the housing (1).

8. The housing (1) according to any one of Claims 1 to 7, **characterized in that** multiple retaining devices each having a retaining web (23) and a guiding device (29) are arranged next to one another with respect to the installation direction (B).

9. A system for fastening a cable (19), comprising a housing (1) according to any one of Claims 1 to 8 and an elongated flexible fastening member (25) in the form of a cable tie.

10. A method for fastening a cable (19) to a housing (1) according to any one of Claims 1 to 8, **characterized in that** a portion of the cable (19) is laid onto an installation area (27) of the retaining web (23), **in that** a flexible elongated fastening member (25) is pushed downwards from the operating side (C) laterally past the cable (19) and the retaining web (23), **in that** the front end of the fastening member (25) is deflected by the guide surface (31) of the deflecting device (29) and is guided upwards again on the other side of the retaining web (23), and **in that** the two ends of the fastening member (25) are tightened and connected to one another.

## Revendications

1. Boîtier (1) destiné à un composant électronique, comprenant un dispositif de maintien doté d'au moins un corps de maintien (23), qui comporte une zone d'application pour appliquer un câble (19) dans une direction d'application (B) et une portion de fixation dégagée pour fixer ce câble au corps de maintien (23) au moyen d'un organe de fixation (25) flexible allongé, un dispositif de guidage (29) doté d'une surface de guidage (31) étant conçu pour faire passer une extrémité avant de l'organe de fixation (25) autour du corps de maintien (23) sur le côté opposé à la zone d'application du corps de maintien (23), quand ladite extrémité est amenée par un côté utilisation (C), de telle sorte qu'elle peut être de nouveau attrapée du côté utilisation (C), **caractérisé en ce que** le corps de maintien (23) est disposé sur une partie de boîtier primaire (la), qui peut être reliée à une partie de boîtier secondaire (1b) de manière pouvant être de nouveau séparée, et **en ce qu'**au moins une portion (29a, 29b) du dispositif de guidage (29) est disposée avec une portion (31a, 31b) correspondante de la surface de guidage (31) sur la partie de boîtier primaire (1a) et une portion (29c) du dispositif de guidage (29) est disposée avec une portion (31c) correspondante sur la partie de boîtier secondaire (1b).

2. Boîtier (1) selon la revendication 1, **caractérisé en ce que** la largeur (E) de la surface de guidage (31) est supérieure à la largeur (F) du corps de maintien (23), de telle sorte que la surface de guidage (31) dépasse du corps de maintien (23) transversalement à la direction d'application (B).

3. Boîtier (1) selon l'une quelconque des revendications 1 et 2, **caractérisé en ce que** le corps de maintien (23) et/ou l'au moins une portion (29a, 29b) du dispositif de guidage (29) sont ancrés sur la partie de boîtier primaire (1a) des deux côtés de la portion de fixation dans la direction d'application (B).

4. Boîtier (1) selon l'une quelconque des revendications 1 à 3, **caractérisé en ce que**, vus dans la direction d'application (B), le corps de maintien (23) et l'au moins une portion (29a, 29b) du dispositif de guidage (29) ne comportent pas de contre-dépouille.

5. Boîtier (1) selon la revendication 4, **caractérisé en ce que** la partie de boîtier primaire (1a) comprend deux portions (31a, 31b) de la surface de guidage (31), qui, vues dans la direction d'application (B), lorsque le boîtier (1) est assemblé, sont adjacentes des deux côtés à la portion (31c) de la surface de guidage (31) sur la partie de boîtier secondaire (1b).

6. Boîtier (1) selon l'une quelconque des revendications 1 à 5, **caractérisé en ce que** les portions (31a, 31b, 31c) de la surface de guidage (31) comportent une courbure concave par rapport au corps de maintien (23).

7. Boîtier (1) selon l'une quelconque des revendications 1 à 6, **caractérisé en ce que** le dispositif de maintien est disposé adjacent à un évidement (17) dans la paroi latérale (5) du boîtier (1).

8. Boîtier (1) selon l'une quelconque des revendications 1 à 7, **caractérisé en ce que** plusieurs dispositifs de maintien comprenant respectivement un corps de maintien (23) et un dispositif de guidage (29) sont disposés les uns à côté des autres par rapport à la direction d'application (B).

9. Système de fixation d'un câble (19) comprenant un boîtier (1) selon l'une quelconque des revendications 1 à 8 et un organe de fixation (25) flexible allongé sous la forme d'un serre-câble.

10. Procédé de fixation d'un câble (19) sur un boîtier (1) selon l'une quelconque des revendications 1 à 8, **caractérisé en ce qu'**une portion du câble (19) est appliquée sur une zone d'application (27) du corps de maintien (23), **en ce qu'**un organe de fixation (25) allongé flexible est poussé vers le bas par le côté utilisation (C) en passant à côté du câble (19) et du corps de maintien (23), **en ce que** l'extrémité avant de l'organe de fixation (25) change de direction au moyen de la surface de guidage (31) du dispositif de renvoi (29) et est guidée de l'autre côté du corps de maintien (23) de nouveau vers le haut, et **en ce que** les deux extrémités de l'organe de fixation (25) sont serrées et reliées l'une à l'autre.
